# EUROPEAN PATENT APPLICATION

(11) **EP 4 768 950 A1**
(43) Date of publication of application: **01.07.2026**
(21) Application number: 24913263.0
(22) Date of filing: 14.08.2024
(51) Int. Cl.: G01R 31/385, G01R 19/165, G01R 19/00, G01R 31/371, H01M 10/48, H01M 50/569, H01M 10/42

(54) **BATTERY AND OPERATION METHOD THEREOF**

(30) Priority: 26.12.2023 KR 20230190771
(71) Applicant: LG Energy Solution, Ltd., Seoul 07335 (KR)
(72) Inventor: SONG, Woo Seok, Daejeon 34122 (KR)
(74) Representative: Plasseraud IP
(86) International application number: PCT/KR2024/012151
(87) International publication number: WO 2025/143422

(57) **Abstract**

A battery according to one embodiment disclosed herein may include a first measurement unit configured to measure a first voltage, which is a voltage between a first busbar connecting a first battery cell to a second battery cell and a second busbar connecting a third battery cell to a fourth battery cell, and transmit the first voltage to a management unit, a second measurement unit configured to measure a second voltage, which is a voltage between a third busbar connecting the second battery cell to the third battery cell and a fourth busbar connecting the fourth battery cell to a fifth battery cell, and transmit the second voltage to the management unit, and the management unit configured to calculate a voltage of the third battery cell by mathematically calculating the first voltage and the second voltage.

## Description

### Technical Field

### CROSS-REFERENCE TO RELATED APPLICATION

This application claims priority to and the benefit of Korean Patent Application No. 10-2023-0190771 filed in the Korean Intellectual Property Office on December 26, 2023, the entire contents of which are incorporated herein by reference.

### TECHNICAL FIELD

Embodiments disclosed herein relate to a battery and a method of operating the same.

### Background Art

Recently, research and development on secondary batteries has been actively conducted. Here, the secondary battery is a battery capable of charging and discharging and means including all recent lithium ion batteries such as conventional Ni/Cd batteries and Ni/MH batteries. Among secondary batteries, lithium-ion batteries have an advantage of having a much higher energy density than conventional Ni/Cd batteries, Ni/MH batteries, etc. In addition, the lithium-ion batteries may be manufactured in a compact and lightweight form, and thus are used as a power source for a mobile device. In addition, the lithium-ion batteries are attracting attention as a next-generation energy storage medium as a range of use expands to a power source for an electric vehicle.

A battery may include a battery module configured by connecting a plurality of battery cells in series. However, when the plurality of battery cells connected in series have a battery cell form with a long distance between electrodes (e.g., a bidirectional tab pouch cell), there is a problem that a sensing line from two electrodes of each battery cell to an inter connected board (ICB) or a module battery management system (BMS) should be configured to measure a voltage of each battery cell, and voltage data should be transmitted to an upper level controller using a separate wireless IC.

### Disclosure

### Technical Problem

Embodiments disclosed herein are directed to providing a battery and a method of operating the same, which may efficiently measure a battery cell voltage.

Embodiments disclosed herein are also directed to providing a battery and a method of operating the same, which may simplify an internal configuration and/or wiring of a battery.

The technical objects of the embodiments disclosed herein are not limited to the above-described technical objects, and other objects that are not described will be able to be clearly understood by those skilled in the art from the following descriptions.

### Technical Solution

A battery according to one embodiment disclosed herein may include a first measurement unit configured to measure a first voltage, which is a voltage between a first busbar connecting a first battery cell to a second battery cell and a second busbar connecting a third battery cell to a fourth battery cell, and transmit the first voltage to a management unit, a second measurement unit configured to measure a second voltage, which is a voltage between a third busbar connecting the second battery cell to the third battery cell and a fourth busbar connecting the fourth battery cell to a fifth battery cell, and transmit the second voltage to the management unit, and the management unit configured to calculate a voltage of the third battery cell by mathematically calculating the first voltage and the second voltage.

In one embodiment, the management unit may calculate each of a first intermediate voltage and a second intermediate voltage by bisecting the first voltage.

In one embodiment, the management unit may calculate a third intermediate voltage by subtracting the second intermediate voltage from the second voltage.

In one embodiment, the management unit may calculate each of a fourth intermediate voltage and a fifth intermediate voltage by bisecting the second voltage.

In one embodiment, the management unit may acquire a sixth intermediate voltage by averaging the third intermediate voltage and the fourth intermediate voltage.

In one embodiment, the management unit may calculate a voltage of the third battery cell by subtracting the sixth intermediate voltage from the second voltage.

In one embodiment, the management unit may calculate a voltage of at least any one of the first battery cell, the second battery cell, and the fourth battery cell using the voltage of the third battery cell.

In one embodiment, the first measurement unit and the second measurement unit may each include a wireless communication module for communicating with the management unit.

A method of operating a battery according to one embodiment disclosed herein may include an operation of measuring a first voltage, which is a voltage between a first busbar connecting a first battery cell to a second battery cell and a second busbar connecting a third battery cell to a fourth battery cell, an operation of measuring a second voltage, which is a voltage between a third busbar connecting the second battery cell to the third battery cell and a fourth busbar connecting the fourth battery cell to a fifth battery cell, and an operation of calculating a voltage of the third battery cell by mathematically calculating the first voltage and the second voltage.

In one embodiment, the operation of calculating the voltage of the third battery cell by mathematically calculating the first voltage and the second voltage may include an operation of calculating each of a first intermediate voltage and a second intermediate voltage by bisecting the first voltage, an operation of calculating a third intermediate voltage by subtracting the second intermediate voltage from the second voltage, an operation of calculating each of a fourth intermediate voltage and a fifth intermediate voltage by bisecting the second voltage, and an operation of calculating the voltage of the third battery cell using the third intermediate voltage and the fourth intermediate voltage.

In one embodiment, the operation of calculating the voltage of the third battery cell using the third intermediate voltage and the fourth intermediate voltage may include an operation of acquiring a sixth intermediate voltage by averaging the third intermediate voltage and the fourth intermediate voltage, and an operation of calculating the voltage of the third battery cell by subtracting the sixth intermediate voltage from the second voltage.

In one embodiment, the method may further include an operation of calculating a voltage of at least any one of the first battery cell, the second battery cell, and the fourth battery cell using the voltage of the third battery cell.

### Advantageous Effects

According to the battery and the method of operating the same according to the embodiments disclosed herein, it is possible to efficiently measure the battery cell voltage.

According to the battery and the method of operating the same according to the embodiments disclosed herein, it is possible to simplify the internal configuration and/or wiring of the battery.

### Description of Drawings

FIG. 1 is a view showing a battery according to one embodiment disclosed herein.
FIG. 2 is a view more specifically showing the battery according to one embodiment disclosed herein.
FIG. 3 is a view showing a configuration of the battery according to one embodiment disclosed herein.
FIGS. 4 to 6 are flowcharts showing a method of operating the battery according to one embodiment disclosed herein.
FIG. 7 shows a computing system for executing a method of operating another battery device according to one embodiment disclosed herein.

### Mode for Invention

Hereinafter, embodiments disclosed herein will be described in detail with reference to exemplary drawings. In adding reference numerals to components in each drawing, it should be noted that the same components have the same reference numerals as much as possible even when they are shown in different drawings. In addition, in describing embodiments disclosed herein, the detailed description of related known configurations or functions will be omitted when it is determined that the detailed description obscures the understanding of the embodiments disclosed herein.

The terms, such as first, second, A, B, (a), and (b) may be used to describe components of the embodiments disclosed in this document. These terms are only for the purpose of distinguishing one component from another component, and the nature, sequence, order, or the like of the corresponding component is not limited by the terms. In addition, unless otherwise defined, all terms (including technical and scientific terms) used herein have the same meanings as those commonly understood by those skilled in the art to which embodiments disclosed herein pertains. The terms defined in a generally used dictionary should be construed as meanings that match with the meanings of the terms from the context of the related technology and are not construed as an ideal or excessively formal meaning unless clearly defined in this application.

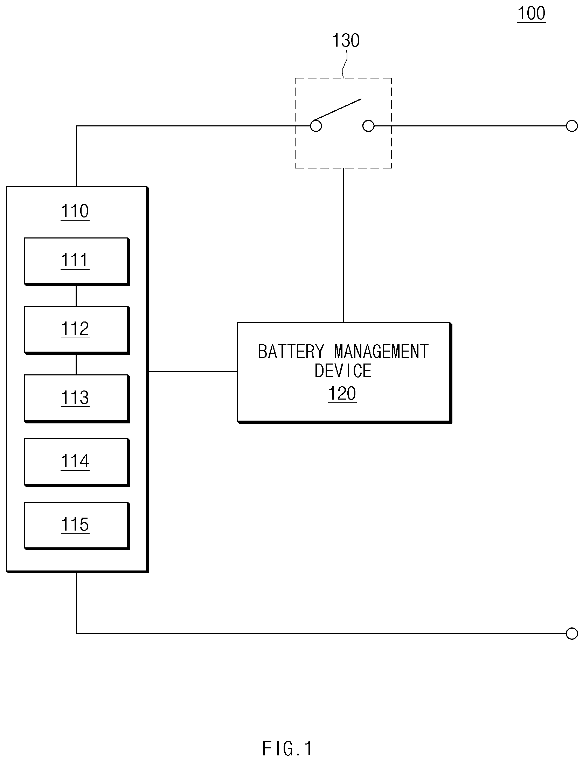

FIG. 1 is a view showing a battery according to one embodiment disclosed herein.

Referring to FIG. 1, a battery 100 according to one embodiment disclosed herein may include a battery module 110, a battery management device 120, and a relay 130.

According to various embodiments, the battery 100 may include a battery pack, and the following description will be made assuming that the battery 100 is the battery pack. In addition, although FIG. 1 shows a case where the battery management device 120 is included in the battery 100 as an example, but the present document is not limited thereto, and the battery management device 120 may be configured as a separate device from the battery 100.

The battery module 110 may include a plurality of battery cells 111, 112, 113, 114, and 115. Although FIG. 1 shows five battery cells, the present document is not limited thereto, and the battery module 110 may include n (n is a natural number of 2 or more) battery cells. According to an embodiment, the plurality of battery cells 111, 112, 113, 114, and 115 may be connected in series. The plurality of battery cells 111, 112, 113, 114, and 115 may be lithium-ion (Li-ion) batteries, lithium-ion polymer (Li-ion polymer) batteries, nickel-cadmium (Ni-Cd) batteries, nickel-metal hydride (Ni-MH) batteries, etc., but are not limited thereto.

According to various embodiments, when the battery pack 100 has a cell-to-pack (CTP) structure, the battery pack 100 may include the plurality of battery cells 111, 112, 113, 114, and 115 without a separate distinct component such as the battery module 110.

Meanwhile, although FIG. 1 shows one battery module 110, according to an embodiment, a plurality of battery modules 110 may be configured.

The battery module 110 may supply power to a target device (not shown). To this end, the battery module 110 may be electrically connected to the target device. Here, the target device may include an electrical, electronic, or mechanical device operated by receiving power from the battery pack 100 including the plurality of battery cells 111, 112, 113, 114, and 115, and for example, the target device may be an electric vehicle (EV), but is not limited thereto.

The battery management device 120 may manage states of the battery module 110, the plurality of battery cells 111, 112, 113, 114, and 115, and/or the battery pack 100. According to various embodiments, the battery management device 120 may include a battery management system (BMS), and an operation of the battery management device 120 may be performed by the BMS and may also be performed by various devices such as a server, a cloud charger, and a charger/discharger.

According to an embodiment, the battery management device 120 may manage and/or control the state and/or operation of the battery module 110. For example, the battery management device 120 may manage and/or control the states and/or operations of the plurality of battery cells 111, 112, 113, 114, and 115 included in the battery module 110. The battery management device 120 may manage charging and/or discharging of the battery module 110.

In addition, the battery management device 120 may monitor a voltage, current, temperature, etc. of the battery module 110 and/or each of the plurality of battery cells 111, 112, 113, 114, and 115 included in the battery module 110. In addition, for monitoring using the battery management device 120, sensors (e.g., a gas sensor and a temperature sensor) (not shown) or various measurement modules (not shown) may be additionally installed at the battery module 110, a charging/discharging path, or any location of the battery module 110, etc. The battery management device 120 may calculate a parameter representing the state of the battery module 110, such as a state of charge (SOC) or state of health (SOH), based on measured values of the monitored voltage, current, temperature, etc.

According to an embodiment, the battery management device 120 may control an operation of the relay 130. For example, the battery management device 120 may make the relay 130 short to supply power to the target device. In addition, the battery management device 120 may make the relay 130 short when a charging device is connected to the battery pack 100. Although FIG. 1 shows one relay 130, according to various embodiments, a plurality of relays 120 may be configured.

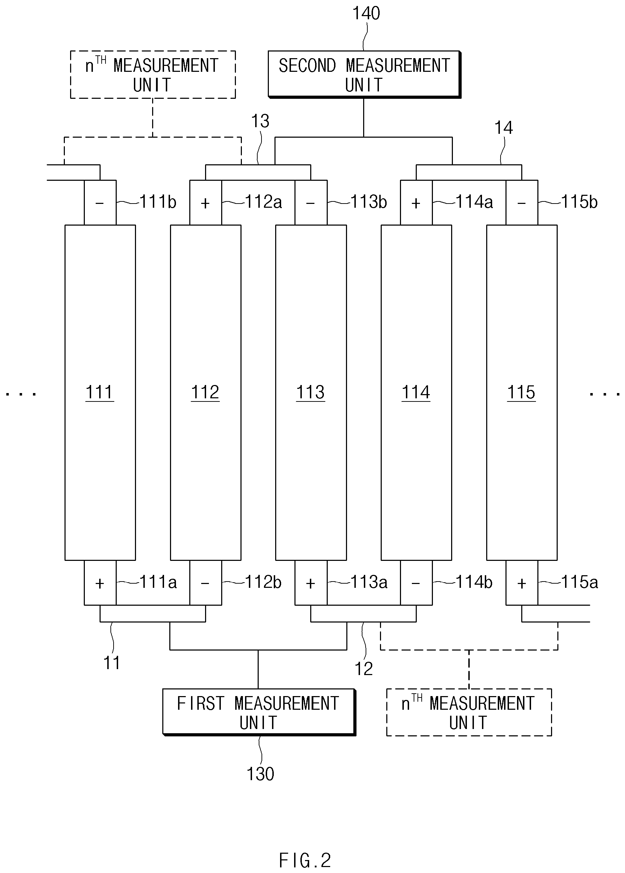

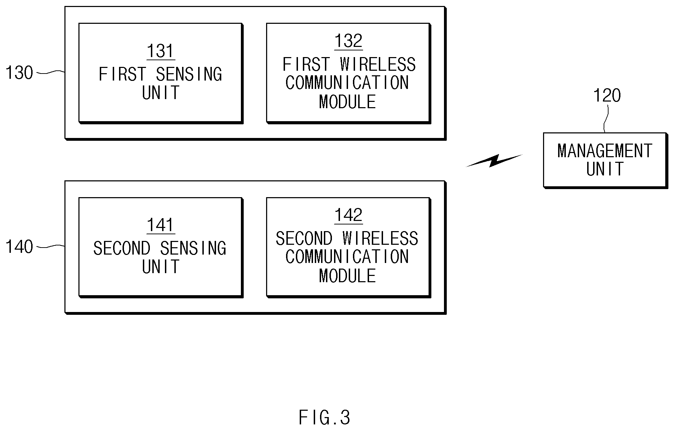

Hereinafter, the operation of the battery 100 acquiring voltages of the plurality of battery cells 111, 112, 113, 114, and 115 will be described in more detail with reference to FIGS. 2 and 3.

FIG. 2 is a view more specifically showing the battery according to one embodiment disclosed herein. FIG. 3 is a view showing a configuration of the battery according to one embodiment disclosed herein.

Referring to FIGS. 2 and 3, the plurality of battery cells 111, 112, 113, 114, and 115 may be connected in series through a busbar.

According to an embodiment, the plurality of battery cells 111, 112, 113, 114, and 115 may have a bidirectional electrode tab structure. For example, the first battery cell 111 may include a positive (+) electrode tab 111a and a negative (-) electrode tab 111b. The second battery cell 112 may include a positive (+) electrode tab 112a and a negative (-) electrode tab 112b. The third battery cell 113 may include a positive (+) electrode tab 113a and a negative (-) electrode tab 113b. The fourth battery cell 114 may include a positive (+) electrode tab 114a and a negative (-) electrode tab 114b. The fifth battery cell 115 may include a positive (+) electrode tab 115a and a negative (-) electrode tab 115b.

According to an embodiment, the first battery cell 111 and the second battery cell 112 may be connected in series through a first busbar 11. That is, the first busbar 11 may electrically connect the positive (+) electrode tab 111a of the first battery cell 111 to the negative (-) electrode tab 112b of the second battery cell 112.

Similarly, the third battery cell 113 and the fourth battery cell 114 may be connected in series through a second busbar 12. That is, the second busbar 12 may electrically connect the positive (+) electrode tab 113a of the third battery cell 113 to the negative (-) electrode tab 114b of the fourth battery cell 114.

In addition, the second battery cell 112 and the third battery cell 113 may be connected in series through a third busbar 13. That is, the third busbar 13 may electrically connect the positive (+) electrode tab 112a of the second battery cell 111 to the negative (-) electrode tab 113b of the third battery cell 112.

The fourth battery cell 114 and the fifth battery cell 115 may be connected in series through a fourth busbar 14. That is, the fourth busbar 14 may electrically connect the positive (+) electrode tab 114a of the fourth battery cell 114 to the negative (-) electrode tab 115b of the fifth battery cell 115.

A first measurement unit 130 may measure a voltage between the first busbar 11 and the second busbar 12. According to an embodiment, the first measurement unit 130 may be manufactured in the form of a flexible substrate and disposed on the first busbar 11 and/or the second busbar 12, but is not limited thereto.

The first measurement unit 130 may include a first sensing unit 131 and a first wireless communication module 132. The first sensing unit 131 may acquire a first voltage V1 by sensing/measuring the voltage between the first busbar 11 and the second busbar 12. Here, the first voltage V1 may be a value that includes both voltages of the second battery cell 112 and the third battery cell 113 connected in series. The first wireless communication module 132 may transmit the measured first voltage V1 to a management unit 120.

A second measurement unit 140 may measure a voltage between the third busbar 13 and the fourth busbar 14. According to an embodiment, the second measurement unit 140 may be manufactured in the form of a flexible substrate and disposed on the third busbar 13 and/or the fourth busbar 14, but is not limited thereto.

The second measurement unit 140 may include a second sensing unit 141 and a second wireless communication module 142. The second sensing unit 141 may acquire a second voltage V2 by sensing/measuring the voltage between the third busbar 13 and the fourth busbar 14. Here, the second voltage V2 may be a value that includes both voltages of the third battery cell 113 and the fourth battery cell 114 connected in series. The second wireless communication module 142 may transmit the measured second voltage V2 to the management unit 120.

Although FIG. 2 shows the first measurement unit 130 and the second measurement unit 140 as an example, the present document is not limited thereto, and a measurement unit (n^{th} measurement unit) is disposed between adjacent busbars (e.g., the third busbar 13 and a busbar at the negative (-) electrode tab side of the first battery cell 111) to sense/measure a voltage between the busbars.

Hereinafter, an operation of the management unit 120 calculating the voltages of the plurality of battery cells 111, 112, 114, and 115 in addition to the third battery cell 113 through mathematical calculation will be described. As described above, hereinafter, the first voltage V1 may be a value that includes both the voltages of the second battery cell 112 and the third battery cell 113 connected in series, and the second voltage V2 may be a value that includes both the voltages of the third battery cell 113 and the fourth battery cell 114 connected in series.

The management unit 120 may calculate each of a first intermediate voltage V_L1 and a second intermediate voltage V_U1 by bisecting the first voltage V1. The management unit 120 may calculate a third intermediate voltage V_U2(1) by subtracting the second intermediate voltage V_U1 from the second voltage V2. In addition, the management unit 120 may calculate each of a fourth intermediate voltage V_U2 and a fifth intermediate voltage V_L2 by bisecting the second voltage V2.

The management unit 120 may acquire a sixth intermediate voltage V_avg by averaging the third intermediate voltage V_U2(1) and the fourth intermediate voltage V_U2, but is not limited thereto, and the management unit 120 may acquire the sixth intermediate voltage V_Uavg by calculating the third intermediate voltage V_U2(1) and the fourth intermediate voltage V_U2 through various mathematical calculations. The management unit 120 may calculate a voltage Vcell3 of the third battery cell 113 by subtracting the sixth intermediate voltage V_Uavg from the second voltage V2.

That is, the management unit 120 may calculate the voltage Vcell3 of the third battery cell 113 through mathematical calculation based on the voltage Vcell3 of the third battery cell 113 being commonly included in the first voltage V1 between the first busbar 11 and the second busbar 12 and the second voltage V2 between the third busbar 13 and the fourth busbar 14.

The management unit 120 may calculate the voltage of each of the plurality of battery cells 111, 112, 114, and 115 by repeatedly performing the above-described operation.

In addition, according to various embodiments, the management unit 120 may calculate a voltage Vcell2 of the second battery cell 112 by subtracting the voltage Vcell3 of the third battery cell 113 from the first voltage V1 and may also calculate a voltage Vcell4 of the fourth battery cell 114 by subtracting the voltage Vcell3 of the third battery cell 113 from the second voltage V2.

According to various embodiments, the management unit 120 may include a battery pack BMS.

Since general cell voltage measurement technologies measure a cell voltage by configuring a sensing line connected to an inter connected board (ICB) or a module BMS from each of two electrode tabs of each cell, there is a problem that a separate component for cell voltage measurement is required and a wiring line is complicated. However, according to the embodiments disclosed herein, the first measurement unit 130 and the second measurement unit 140 may directly transmit the sensed/measured first voltage V1 and second voltage V2 to the management unit 120 via wireless communication, respectively, and as will be described below, the management unit 120 may calculate the voltages of the plurality of battery cells 111, 112, 114, and 115 in addition to the third battery cell 113 by mathematically calculating the first voltage V1 and the second voltage V2, thereby efficiently measuring the battery cell voltage and simplifying the internal configuration and/or wiring of the battery 100.

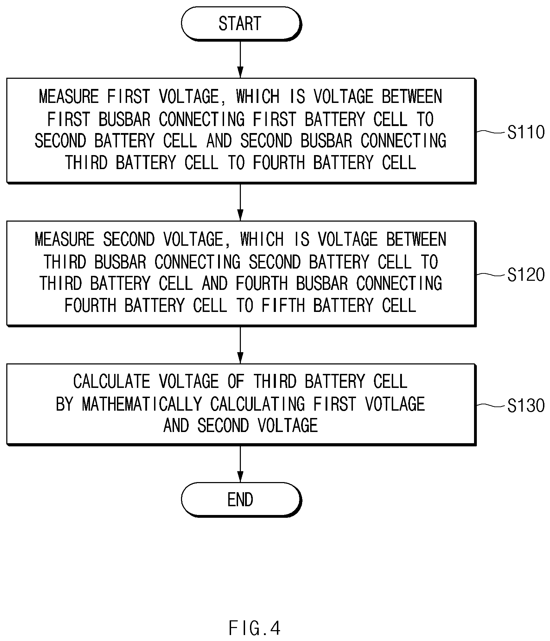

FIGS. 4 to 6 are flowcharts showing a method of operating the battery according to one embodiment disclosed herein.

First, referring to FIG. 4, the method of operating the battery according to one embodiment disclosed herein may include an operation of measuring a first voltage, which is a voltage between a first busbar connecting a first battery cell to a second battery cell and a second busbar connecting a third battery cell to a fourth battery cell (S110), an operation of measuring a second voltage, which is a voltage between a third busbar connecting the second battery cell to the third battery cell and a fourth busbar connecting the fourth battery cell to a fifth battery cell (S120), and an operation of calculating a voltage of the third battery cell by mathematically calculating the first voltage and the second voltage (S130).

Hereinafter, operations S110 to S130 will be described in detail with reference to FIGS. 2 and 3.

In operation S110, the first sensing unit 131 of the first measurement unit 130 may acquire the first voltage V1 by sensing/measuring the voltage between the first busbar 11 and the second busbar 12. Here, the first voltage V1 may be a value that includes both voltages of the second battery cell 112 and the third battery cell 113 connected in series. The first wireless communication module 132 of the first measurement unit 130 may transmit the measured first voltage V1 to the management unit 120.

In operation S120, the second sensing unit 141 of the second measurement unit 140 may acquire the second voltage V2 by sensing/measuring the voltage between the third busbar 13 and the fourth busbar 14. Here, the second voltage V2 may be a value that includes both voltages of the third battery cell 113 and the fourth battery cell 114 connected in series. The second wireless communication module 142 may transmit the measured second voltage V2 to the management unit 120.

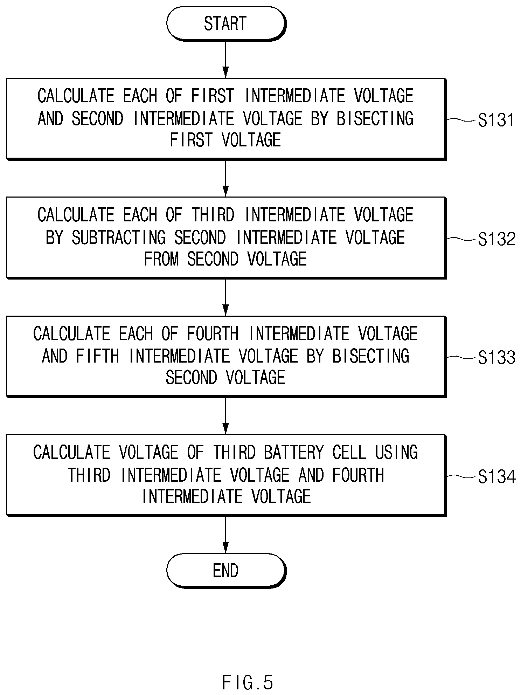

In operation S130, the management unit 120 may calculate the voltage Vcell3 of the third battery cell 113 by mathematically calculating the first voltage V1 and the second voltage V2. Operation S130 may include operations S131 to S134 shown in FIG. 5.

Referring to FIG. 5, operation S130 may include an operation of calculating each of a first intermediate voltage and a second intermediate voltage by bisecting the first voltage (S131), an operation of calculating a third intermediate voltage by subtracting the second intermediate voltage from the second voltage (S132), an operation of calculating each of a fourth intermediate voltage and a fifth intermediate voltage by bisecting the second voltage (S133), and an operation of calculating the voltage of the third battery cell using the third intermediate voltage and the fourth intermediate voltage (S134).

In operation S131, the management unit 120 may calculate each of the first intermediate voltage V_L1 and the second intermediate voltage V_U1 by bisecting the first voltage V1.

In operation S132, the management unit 120 may calculate the third intermediate voltage V_U2(1) by subtracting the second intermediate voltage V_U1 from the second voltage V2.

In operation S133, the management unit 120 may calculate each of the fourth intermediate voltage V_U2 and the fifth intermediate voltage V_L2 by bisecting the second voltage V2.

In operation S134, the management unit 120 may calculate the voltage Vcell3 of the third battery cell 113 using the third intermediate voltage V_U2(1) and the fourth intermediate voltage V_U2.

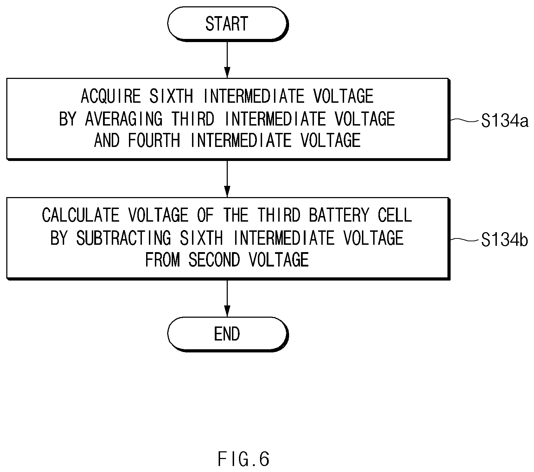

Referring to FIG. 6, operation S134 may include an operation of acquiring a sixth intermediate voltage by averaging the third intermediate voltage and the fourth intermediate voltage (S134a), and an operation of calculating the voltage of the third battery cell by subtracting the sixth intermediate voltage from the second voltage (S134b).

In operation S134a, the management unit 120 may acquire the sixth intermediate voltage V by averaging the third intermediate voltage V_U2(1) and the fourth intermediate voltage V_U2, but is not limited thereto, and the management unit 120 may acquire the sixth intermediate voltage V_Uavg by calculating the third intermediate voltage V_U2(1) and the fourth intermediate voltage V_U2 through various mathematical calculations.

In operation S134b, the management unit 120 may calculate the voltage Vcell3 of the third battery cell 113 by subtracting the sixth intermediate voltage V_Uavg from the second voltage V2.

That is, the management unit 120 may calculate the voltage Vcell3 of the third battery cell 113 through mathematical calculation based on the voltage Vcell3 of the third battery cell 113 being commonly included in the first voltage V1 between the first busbar 11 and the second busbar 12 and the second voltage V2 between the third busbar 13 and the fourth busbar 14.

Furthermore, the management unit 120 may calculate the voltage of each of the plurality of battery cells 111, 112, 114, and 115 by repeatedly performing the above-described operation. In addition, according to various embodiments, the management unit 120 may calculate a voltage Vcell2 of the second battery cell 112 by subtracting the voltage Vcell3 of the third battery cell 113 from the first voltage V1 and may also calculate a voltage Vcell4 of the fourth battery cell 114 by subtracting the voltage Vcell3 of the third battery cell 113 from the second voltage V2.

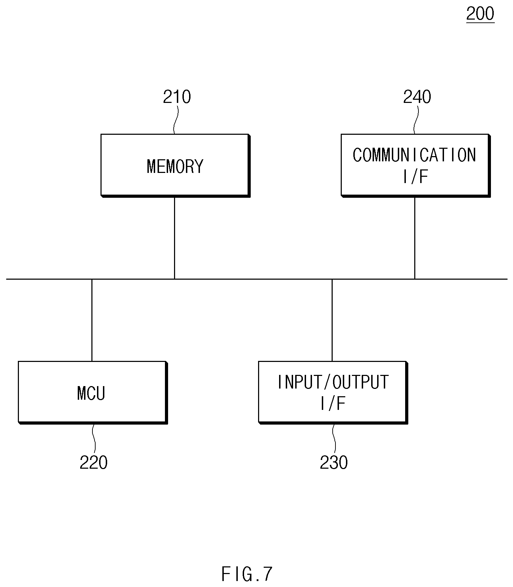

FIG. 7 is a computing system for executing a method of operating another battery according to one embodiment disclosed herein.

Referring to FIG. 7, a computing system 200 according to one embodiment disclosed herein may include a micro controller unit (MCU) 210, a memory 220, an input/output I/F 230, and a communication I/F 240.

The MCU 210 may be a processor for executing various programs (e.g., a battery cell voltage calculation program) stored in the memory 220 and performing functions of the battery management device 120 described with reference to FIGS. 1 to 3 or a processor for executing the method of operating the battery described with reference to FIGS. 4 to 6.

The memory 220 may store various programs related to calculating SOH of a battery cell and determining a target on which cell balancing is performed, a battery bad fastening determination program, a battery data transmission program, a battery diagnosis program, a battery cell voltage calculation program, etc. In addition, the memory 220 may store various pieces of data such as a voltage, SOC and SOH data, sensing value, and temperature of each battery cell.

A plurality of memories 220 may be provided as needed. The memory 220 may be a volatile memory or a non-volatile memory. As the memory 220 of the volatile memory, a RAM, a DRAM, a SRAM, or the like can be used. As the memory 220 of the non-volatile memory, a ROM, a PROM, an EAROM, an EPROM, an EEPROM, a flash memory, or the like can be used. Examples of the above-listed memories 220 are merely illustrative and are not limited to these examples.

The input/output I/F 230 may be an interface for connecting an input device (not shown), such as a keyboard, a mouse, or a touch panel, and an output device, such as a display (not shown) with the MCU 210 and allowing the input and output devices and the MCU 4610 to transmit and receive data.

The communication I/F 240 is a component capable of transmitting and receiving various data to and from the server and may be various devices capable of supporting wired or wireless communication. For example, a program, various pieces of data, a battery data transmission program, a battery diagnosis program, etc. for calculating the SOH of the battery cell or determining the balancing target may be transmitted and received from a separately provided external server through the communication I/F 240.

As described above, the method of operating the battery management device according to one embodiment disclosed herein may be stored in the memory 220 and executed by the MCU 210.

The above description is merely the exemplary description of the technical spirit disclosed herein, and those skilled in the art to which embodiments disclosed herein pertain will be able to variously modify and change the present document without departing from the essential characteristics of the embodiments disclosed herein.

Therefore, the embodiments disclosed herein are not intended to limit the technical spirit disclosed herein, but for describing it, and the scope of the technical spirit disclosed herein is not limited by these embodiments. The scope of the technical spirit disclosed herein should be construed by the appended claims, and all technical spirits within the equivalent range should be construed as being included in the scope of this document.

## Claims

1. A battery comprising:
a first measurement unit configured to measure a first voltage, which is a voltage between a first busbar connecting a first battery cell to a second battery cell and a second busbar connecting a third battery cell to a fourth battery cell, and transmit the first voltage to a management unit;
a second measurement unit configured to measure a second voltage, which is a voltage between a third busbar connecting the second battery cell to the third battery cell and a fourth busbar connecting the fourth battery cell to a fifth battery cell, and transmit the second voltage to the management unit; and
the management unit configured to calculate a voltage of the third battery cell by mathematically calculating the first voltage and the second voltage.

2. The battery of claim 1, wherein the management unit calculates each of a first intermediate voltage and a second intermediate voltage by bisecting the first voltage.

3. The battery of claim 2, wherein the management unit calculates a third intermediate voltage by subtracting the second intermediate voltage from the second voltage.

4. The battery of claim 3, wherein the management unit calculates each of a fourth intermediate voltage and a fifth intermediate voltage by bisecting the second voltage.

5. The battery of claim 4, wherein the management unit acquires a sixth intermediate voltage by averaging the third intermediate voltage and the fourth intermediate voltage.

6. The battery of claim 5, wherein the management unit calculates a voltage of the third battery cell by subtracting the sixth intermediate voltage from the second voltage.

7. The battery of claim 6, wherein the management unit calculates a voltage of at least any one of the first battery cell, the second battery cell, and the fourth battery cell using the voltage of the third battery cell.

8. The battery of claim 1, wherein the first measurement unit and the second measurement unit each include a wireless communication module for communicating with the management unit.

9. A method of operating a battery, comprising:
an operation of measuring a first voltage, which is a voltage between a first busbar connecting a first battery cell to a second battery cell and a second busbar connecting a third battery cell to a fourth battery cell;
an operation of measuring a second voltage, which is a voltage between a third busbar connecting the second battery cell to the third battery cell and a fourth busbar connecting the fourth battery cell to a fifth battery cell; and
an operation of calculating a voltage of the third battery cell by mathematically calculating the first voltage and the second voltage.

10. The method of claim 9, wherein the operation of calculating the voltage of the third battery cell by mathematically calculating the first voltage and the second voltage includes:
an operation of calculating each of a first intermediate voltage and a second intermediate voltage by bisecting the first voltage;
an operation of calculating a third intermediate voltage by subtracting the second intermediate voltage from the second voltage;
an operation of calculating each of a fourth intermediate voltage and a fifth intermediate voltage by bisecting the second voltage; and
an operation of calculating the voltage of the third battery cell using the third intermediate voltage and the fourth intermediate voltage.

11. The method of claim 10, wherein the operation of calculating the voltage of the third battery cell using the third intermediate voltage and the fourth intermediate voltage includes:
an operation of acquiring a sixth intermediate voltage by averaging the third intermediate voltage and the fourth intermediate voltage; and
an operation of calculating the voltage of the third battery cell by subtracting the sixth intermediate voltage from the second voltage.

12. The method of claim 10, further comprising an operation of calculating a voltage of at least any one of the first battery cell, the second battery cell, and the fourth battery cell using the voltage of the third battery cell.
